# EUROPEAN PATENT APPLICATION

(11) **EP 2 830 223 A1**
(43) Date of publication of application: **28.01.2015**
(21) Application number: 13275259.3
(22) Date of filing: 28.10.2013
(51) Int. Cl.: H03L 7/087, H03L 7/093

(54) **Frequency synthesizer and method of controlling the same**

(30) Priority: 22.07.2013 KR 20130086103
(71) Applicant: Samsung Electro-Mechanics Co., Ltd, Suwon, Gyunggi-Do (KR)
(72) Inventor: Kim, Yoo Hwan, Gyunggi-do (KR); Na, Yoo Sam, Gyunggi-do (KR)
(74) Representative: Powell, Timothy John

(57) **Abstract**

There is provided a frequency synthesizer, including: a phase-locked loop unit detecting a phase difference between a frequency of a frequency-divided oscillating signal and a frequency of a reference signal so as to adjust dividing of the frequency of the oscillating signal so that the phase difference is decreased within a range of the correction gain levels; an automatic frequency control unit sequentially searching a plurality of frequency gain levels so as to determine a first gain level corresponding to the phase difference between the frequency of the frequency-divided oscillating signal and the frequency of the reference signal; and a correction unit determining a gain correction value using the first gain level so as to determine the correction gain level by reflecting the gain correction value.

## Description

### CROSS-REFERENCE TO RELATED APPLICATIONS

This application claims the priority of Korean Patent Application No. 10-2013-0086103 filed on July 22, 2013, in the Korean Intellectual Property Office, the disclosure of which is incorporated herein by reference.

### BACKGROUND OF THE INVENTION

### Field of the Invention

The present invention relates to a frequency synthesizer capable of quickly correcting a deviation in frequency to optimize locking time, and a method of controlling the same.

### Description of the Related Art

In wireless communication technologies, a frequency synthesizer is widely used for generating a stable frequency for signal transmission/reception.

A commonly used frequency synthesizer is a phase-locked loop (PLL) that includes a voltage-controlled oscillator.

The phase-locked loop may lock an output frequency of the voltage-controlled oscillator in a feedback control manner, and the voltage-controlled oscillator may use a plurality of capacitor banks to determine an output frequency.

Existing frequency synthesizers, however, require locking time taken to correct a deviation generated by a producing process and the like.

In particular, if divided frequencies and the frequency associated with the capacitor banks are different due to an error in a process or in a circuit; locking time is increased for corrections whenever a frequency is divided.

In order to overcome this shortcoming, an automatic frequency control scheme has been employed for correcting deviations generated due to an error. The auto frequency control scheme requires sequentially searching for frequencies of the capacitor banks in order to set locking due to an error. Therefore, frequency can be correctly locked only after the sequential searching on the capacitor banks is completed, such that locking time for multiple locking is still required.

Patent Document 1 relates to an AFC control apparatus, an AFC control method, an AFC control program and a mobile communication apparatus, and Patent Document 2 relates to automatic frequency control apparatus and method. However, the inventions disclosed in the Patent Documents require sequential locking if a matching deviation exists in the capacitor banks due to an error on an IC and the like, and thus still have the shortcoming of increased locking times.

### [Related Art Documents]

### [Patent Documents]

(Patent Document 1) Korea Patent Publication No. 10-1073920
(Patent Document 2) Japanese Patent Laid-Open Publication No. 2008-205703

### SUMMARY OF THE INVENTION

An aspect of the present invention provides a frequency synthesizer and a method of controlling the same capable of determining a deviation in the first locking process, and reflecting the determined deviation in selecting a capacitor bank, thereby eliminating the sequential locking process and reducing the locking time.

According to an aspect of the present invention, there is provided a frequency synthesizer, including: a phase-locked loop unit detecting a phase difference between a frequency of a frequency-divided oscillating signal and a frequency of a reference signal so as to adjust dividing of the frequency of the oscillating signal so that the phase difference is decreased within a range of the correction gain levels; an automatic frequency control unit sequentially searching a plurality of frequency gain levels so as to determine a first gain level corresponding to the phase difference between the frequency of the frequency-divided oscillating signal and the frequency of the reference signal; and a correction unit determining a gain correction value using the first gain level so as to determine the correction gain level by reflecting the gain correction value.

The phase-locked loop unit may include: a phase comparator receiving the oscillating signal and the reference signal so as to output a phase difference between the frequency of the oscillating signal and the frequency of the reference signal; and a voltage-controlled oscillator receiving a control signal corresponding to the phase difference and adjusting the frequency dividing by reflecting the control signal in the correction gain level so as to oscillate the oscillating signal.

The voltage-controlled oscillator may store a look-up table for a plurality of capacitor banks corresponding to a plurality of frequency gain levels, and may adjust the frequency dividing using a capacitor bank corresponding to the correction gain level.

The correction unit may determine a difference between the first gain level initially determined in the automatic frequency control unit and the input gain level as the gain correction value, and store it.

The corrector may determine the correction gain level by reflecting the stored gain correction value if a new input gain level is input.

The phase-locked loop may include: a charge pump charging or discharging capacitors according to the phase difference output from the phase comparator; and a filter generating the control signal using a current output from the charge pump.

According to another aspect of the present invention, there is provided a frequency synthesizer, including: a phase-locked loop detecting a phase difference between a frequency of a frequency-divided oscillating signal and a frequency of a reference signal so as to adjust dividing of the frequency of the oscillating signal so that the phase difference is decreased within a range of the correction gain levels; an automatic frequency control unit searching a plurality of frequency gain levels so as to determine a first gain level corresponding to the phase difference between the frequency of the frequency-divided oscillating signal and the frequency of the reference signal; and a correction unit determining a gain correction value based on the first gain level by a first operation of the automatic frequency control unit, and reflecting the gain correction value after second operation of the automatic frequency control unit.

The phase-locked loop unit may include: a phase comparator receiving the oscillating signal and the reference signal so as to output a phase difference between the frequency of the oscillating signal and the frequency of the reference signal; and a voltage-controlled oscillator receiving a control signal corresponding to the phase difference and adjusting the frequency dividing by reflecting the control signal in the correction gain level so as to oscillate the oscillating signal.

The voltage-controlled oscillator may store a look-up table for a plurality of capacitor banks corresponding to a plurality of frequency gain levels, and may adjust the frequency dividing using a capacitor bank corresponding to the correction gain level.

The correction unit may determine the gain correction value from a difference between a look-up table for the capacitor bank and the first gain level by the first operation.

The correction unit may determine the correction gain level by reflecting the gain correction value in the look-up table from when the automatic frequency control unit operates for the second time.

The phase-locked loop may include: a charge pump charging or discharging capacitors according to the phase difference output from the phase comparator; and a filter generating the control signal using a current output from the charge pump.

According to another aspect of the present invention, there is provided a method of controlling a frequency synthesizer using capacitor banks, the method including: determining a phase difference between a frequency of a frequency-divided oscillating signal and a frequency of a reference signal; detecting a first gain level corresponding to the phase difference through automatic frequency control; sequentially searching look-up tables for capacitor banks to determine an input gain level corresponding to the phase difference; and calculating a gain correction value from the difference between the first gain level and the input gain level.

The detecting of the first gain level may include determining the first gain level using locking information when the automatic frequency control is operated for the first time.

The method may further include reflecting the gain correction value in the first gain level by the phase difference by the operation from when the automatic frequency control is operated for the second time.

The method may further include dividing the frequency of the oscillating signal again by reflecting the gain correction value, so as to perform the determining of the phase difference again based on the oscillating signal which was frequency-divided again.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a block diagram for illustrating an example of a typical frequency synthesizer;
FIG. 2 is a block diagram for illustrating an example of the frequency synthesizer shown in FIG. 1;
FIG. 3 is a graph showing an example of a capacitor bank applicable to a frequency synthesizer;
FIG. 4 is a block diagram for illustrating a frequency synthesizer according to an embodiment of the present invention;
FIG. 5 is a block diagram for illustrating an example of the frequency synthesizer shown in FIG. 4;
FIG. 6 is a block diagram for illustrating an example of the corrector shown in FIG. 5;
FIG. 7 is a flowchart for illustrating a method of controlling a frequency synthesizer according to an embodiment of the present invention; and
FIG. 8 is a graph showing simulation data according to an embodiment of the present invention.

### DETAILED DESCRIPTION OF THE INVENTION

Hereinafter, embodiments of the present invention will be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art. Throughout the drawings, the same or like reference numerals will be used to designate the same or like elements.

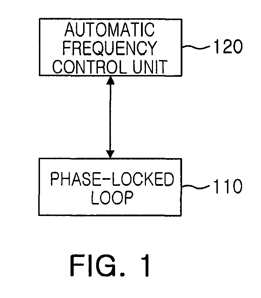

FIG. 1 is a block diagram for illustrating an example of a frequency synthesizer.

Referring to FIG. 1, the frequency synthesizer includes a phase-locked loop unit 110 and an automatic frequency control unit 120.

The phase-locked loop unit 110 detects a phase difference between a previous oscillating signal and a reference signal, and generates a current oscillating signal by adjusting frequency dividing so that the phase difference is decreased. Here, the generated oscillating signal is fed back to the phase-locked loop unit 110.

In adjusting frequency dividing, the phase-locked loop unit 110 may use a predetermined gain level to adjust frequency dividing. The gain level may be determined based on the information provided from the automatic frequency control unit 120.

The automatic frequency control unit 120 generates a gain level determining signal to maintain or change the current frequency gain level depending on the difference in phases between the frequency of the oscillating signal frequency-divided from the phase-locked loop unit 110 and the frequency of the reference signal. The automatic frequency control unit 120 may provide the generated gain level determining signal to the phase-locked loop unit 110. The phase-locked loop unit 110 may determine the gain level depending on the gain level determining signal and may adjust frequency dividing using the determined gain level.

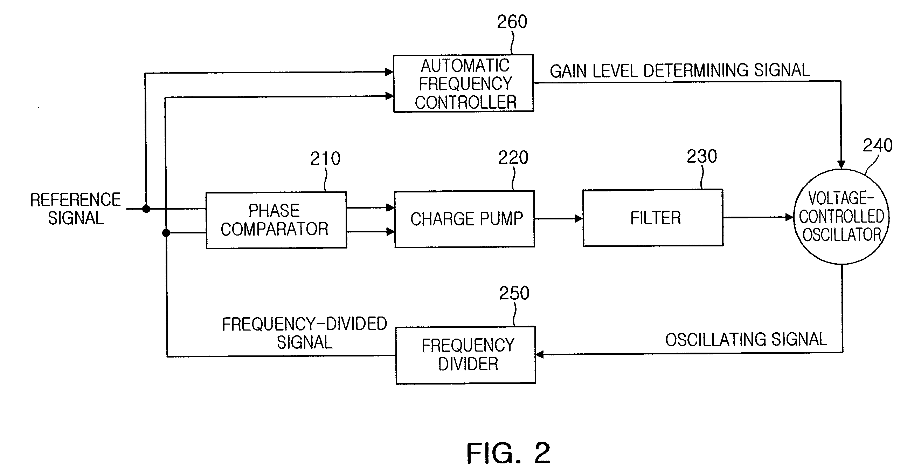

FIG. 2 is a block diagram illustrating an example of the frequency synthesizer shown in FIG. 1. In the following, the example of the frequency synthesizer shown in FIG. 1 will be described in more detail with reference to FIG. 2.

Referring to FIGS. 1 and 2, the phase-locked loop unit 110 may be implemented as a loop type unit, namely, a phase-locked loop as shown. The phase-locked loop unit 110 includes a phase comparator 210, a charge pump 220, a filter 230, a voltage-controlled oscillator 240 and a frequency divider 250.

The phase comparator 210 receives a reference signal and a frequency-divided signal and compares the phases of the frequencies of the two signals. The phase comparator 210 provides an output signal corresponding to the difference in phases between the reference signal and the frequency-divided signal to the charge pump 220.

The charge pump 220 receives an output signal from the phase comparator 210 and outputs a current corresponding thereto. The current output from the charge pump 220 is input to the filter 230, and the filter 230 converts the input current into a voltage so as to provide it to the voltage-controlled oscillator 240. Here, the voltage output from the filter 230 may be used as a control signal to the voltage-controlled oscillator 240.

The voltage-controlled oscillator 240 generates an oscillating signal by adjusting frequency dividing using a control signal output from the filter 230 with reference to a certain frequency gain level.

Here, the frequency gain level may correspond to a capacitor bank of the voltage-controlled oscillator 240. Accordingly, the voltage-controlled oscillator 240 may use a gain level determining signal provided from the automatic frequency controller 260 to determine a capacitor bank used in oscillating.

The frequency divider 240 may divide the frequency of an oscillating signal output from the voltage-controlled oscillator 250 at a predetermined proportion. For example, the frequency divider 250 may divide the frequency of an oscillating signal so that it has the same frequency with a reference signal, so as to generate a frequency-divided signal. Here, the above-described reference signal, oscillating signal and frequency-divided signal may be a voltage signal.

The automatic frequency control unit 120 may also be implemented as a loop type unit. As shown, the automatic frequency control unit 120 may include the voltage-controlled oscillator 240, a frequency divider 250 and the automatic frequency controller 260.

The automatic frequency controller 260 receives a reference signal and a frequency-divided signal and detects the difference between the two signals. Then, the automatic frequency control unit 120 determines whether to change the frequency gain level depending on the difference between the two signals, to create a gain level determining signal. The generated gain level determining signal is input to the voltage-controlled oscillator 240.

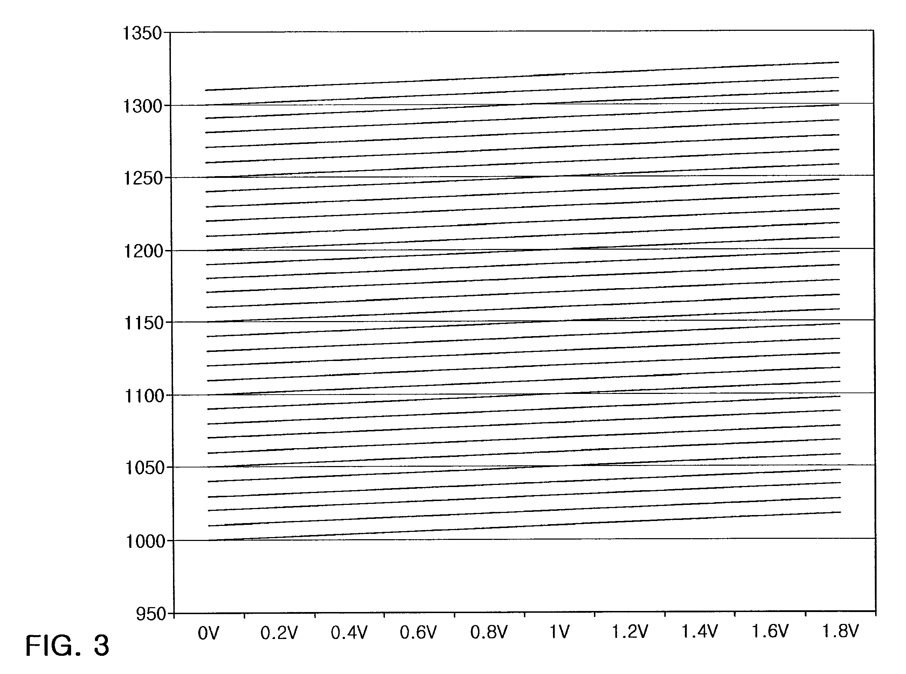

The specific operation of the automatic frequency controller 260 will be described in detail with reference to FIG. 3 and Table 1 below.

FIG. 3 is a graph showing an example of a capacitor bank applicable to a frequency synthesizer, and Table 1 is a look-up table representing the capacitor bank shown in FIG. 3 as a table.

**[Table 1]**

| Cap-bank | 0 | 0.2 | 0.4 | 0.6 | 0.8 | 1 | 1.2 | 1.4 | 1.6 | 1.8 |
|---|---|---|---|---|---|---|---|---|---|---|
| 1 | 1000 | 1002 | 1004 | 1006 | 1008 | 1010 | 1012 | 1014 | 1016 | 1018 |
| 2 | 1010 | 1012 | 1014 | 1016 | 1018 | 1020 | 1022 | 1024 | 1026 | 1028 |
| 3 | 1020 | 1022 | 1024 | 1026 | 1028 | 1030 | 1032 | 1034 | 1036 | 1038 |
| 4 | 1030 | 1032 | 1034 | 1036 | 1038 | 1040 | 1042 | 1044 | 1046 | 1048 |
| 5 | 1040 | 1042 | 1044 | 1046 | 1048 | 1050 | 1052 | 1054 | 1056 | 1058 |
| 6 | 1050 | 1052 | 1054 | 1056 | 1058 | 1060 | 1062 | 1064 | 1066 | 1068 |
| 7 | 1060 | 1062 | 1064 | 1066 | 1068 | 1070 | 1072 | 1074 | 1076 | 1078 |
| 8 | 1070 | 1072 | 1074 | 1076 | 1078 | 1080 | 1082 | 1084 | 1086 | 1088 |
| 9 | 1080 | 1082 | 1084 | 1086 | 1088 | 1090 | 1092 | 1094 | 1096 | 1098 |
| 10 | 1090 | 1092 | 1094 | 1096 | 1098 | 1100 | 1102 | 1104 | 1106 | 1108 |
| 11 | 1100 | 1102 | 1104 | 1106 | 1108 | 1110 | 1112 | 1114 | 1116 | 1118 |
| 12 | 1110 | 1112 | 1114 | 1116 | 1118 | 1120 | 1122 | 1124 | 1126 | 1128 |
| 13 | 1120 | 1122 | 1124 | 1126 | 1128 | 1130 | 1132 | 1134 | 1136 | 1138 |
| 14 | 1130 | 1132 | 1134 | 1136 | 1138 | 1140 | 1142 | 1144 | 1146 | 1148 |
| 15 | 1140 | 1142 | 1144 | 1146 | 1148 | 1150 | 1152 | 1154 | 1156 | 1158 |
| 16 | 1150 | 1152 | 1154 | 1156 | 1158 | 1160 | 1162 | 1164 | 1166 | 1168 |
| 17 | 1160 | 1162 | 1164 | 1166 | 1168 | 1170 | 1172 | 1174 | 1176 | 1178 |
| 18 | 1170 | 1172 | 1174 | 1176 | 1178 | 1180 | 1182 | 1184 | 1186 | 1188 |
| 19 | 1180 | 1182 | 11.84 | 1186 | 1188 | 1190 | 1192 | 1194 | 1196 | 1198 |
| 20 | 1190 | 1192 | 1194 | 1196 | 1198 | 1200 | 1202 | 1204 | 1206 | 1208 |
| 21 | 1200 | 1202 | 1204 | 1206 | 1208 | 1210 | 1212 | 1214 | 1216 | 1218 |
| 22 | 1210 | 1212 | 1214 | 1216 | 1218 | 1220 | 1222 | 1224 | 1226 | 1228 |
| 23 | 1220 | 1222 | 1224 | 1226 | 1228 | 1230 | 1232 | 1234 | 1236 | 1238 |
| 24 | 1230 | 1232 | 1234 | 1236 | 1238 | 1240 | 1242 | 1244 | 1246 | 1248 |
| 25 | 1240 | 1242 | 1244 | 1246 | 1248 | 1250 | 1252 | 1254 | 1256 | 1258 |
| 26 | 1250 | 1252 | 1254 | 1256 | 1258 | 1260 | 1262 | 1264 | 1266 | 1268 |
| 27 | 1260 | 1262 | 1264 | 1266 | 1268 | 1270 | 1272 | 1274 | 1276 | 1278 |
| 28 | 1270 | 1272 | 1274 | 1276 | 1278 | 1280 | 1282 | 1284 | 1286 | 1288 |
| 29 | 1280 | 1282 | 1284 | 1286 | 1288 | 1290 | 1292 | 1294 | 1296 | 1298 |
| 30 | 1290 | 1292 | 1294 | 1296 | 1298 | 1300 | 1302 | 1304 | 1306 | 1308 |
| 31 | 1300 | 1302 | 1304 | 1306 | 1308 | 1310 | 1312 | 1314 | 1316 | 1318 |
| 32 | 1310 | 1312 | 1314 | 1316 | 1318 | 1320 | 1322 | 1324 | 1326 | 1328 |

In FIG. 3, the y-axis represents frequency and the x-axis represents a control signal to the voltage-controlled oscillator 240. In the shown example, the number of the capacitor banks is 32, and their characteristic according to voltage and frequency is shown.

In the shown example, the voltage-controlled oscillator 240 is set such that it outputs 1000 MHz when the control signal is 0 V and outputs 1010 MHz when the control signal is 1 V, with the capacitor bank 1. Here, if a target frequency is 1120 MHz, the capacitor bank is the 12^{th}; the control signal of approximately 1 V may be used.

However, due to a processing error or an issue related to a circuit, the characteristic of the capacitor bank to frequency may be changed. In this case, there is a problem in that the loop should be driven multiple times for frequency locking.

For example, an error may cause 1120 MHz to correspond to the 17th of the capacitor banks instead of the 12th. In this case, the auto frequency controller 260 uses the look-up table to select 12th of the capacitor banks and determines whether it is locked regardless of the error. If it is unlocked, the column of the capacitor banks is incremented by one so as to move to 13th, and it is determined again whether it is locked. Accordingly, the automatic frequency controller 260 repeats the locking process until actual locking is made, that is, repeats six times until 17th column of the capacitor banks is used.

Although the frequency may be adjusted by doing the above operation, it takes relatively long locking time. In the above example, all of the columns from 12th to 17th columns are determined whether they are locked. Therefore, six times more locking time is required.

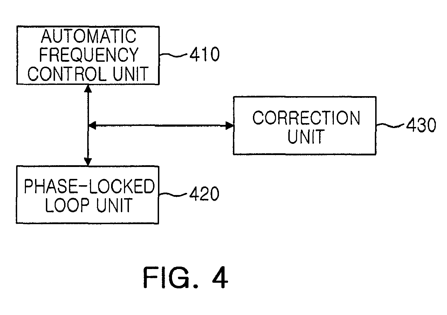

In order to prevent the locking time from increasing, the embodiments of the present invention performs correction for locking. In the following, a frequency synthesizer according to an embodiment of the present invention will be described in detail with reference to FIGS. 4 to 6.

In the following descriptions, an overlapped description for contents that are the same as or correspond to contents described above with reference to FIGS. 1 and 2 will be omitted.

FIG. 4 is a block diagram for illustrating a frequency synthesizer according to an embodiment of the present invention.

Referring to FIG. 4, the frequency synthesizer according to the embodiment includes an automatic frequency control unit 410, a phase-locked loop unit 420 and a correction unit 430.

The automatic frequency control unit 410 sequentially searches a plurality of frequency gain levels, and determines a first gain level corresponding to a phase difference between the frequency of a frequency-divided oscillating signal and the frequency of a reference signal. Here, the first gain level is input to the correction unit 430 and used for determining a correction gain level.

The phase-locked loop unit 420 detects a phase difference between the frequency of a frequency-divided oscillating signal and the frequency of the reference signal. The phase-locked loop unit 420 adjusts the frequency dividing of the oscillating signal such that the phase difference becomes smaller within the range of the correction gain level provided from the correction unit 430.

The correction unit 430 uses the first gain level provided from the automatic frequency control unit 410 to determine the gain correction deviation. The correction unit 430 may use the gain correction value to determine the correction gain level.

In an embodiment, the correction unit 430 may determine the gain correction value by reflecting the firs gain level in the input gain level irrespective of the change in the oscillating signal or the reference signal. That is, even if the oscillating signal or reference signal is changed, the gain correction value may have a constant value, and the gain correction value may be determined from the first driving of the phase-locked loop. To this end, the correction unit 430 may determine the gain correction value based on the first gain level by the first operation of the automatic frequency control unit 410, and may reflect the gain correction value from when the automatic frequency control unit 410 operates for the second time.

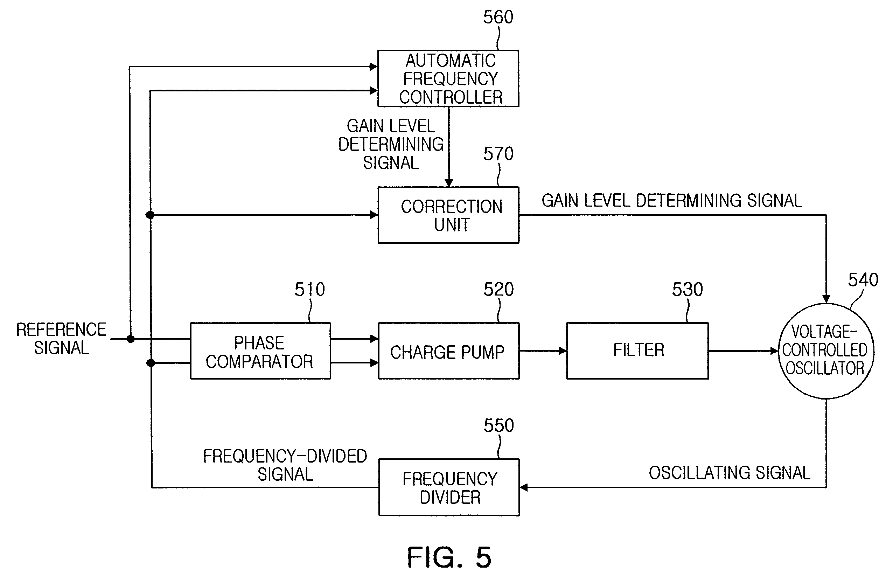

FIG. 5 is a block diagram illustrating an example of the frequency synthesizer shown in FIG. 4. In the following, the example of the frequency synthesizer will be described in more detail with reference to FIG. 5.

Referring to FIGS. 4 and 5, the phase-locked loop unit 410 may be implemented as a loop type unit, namely, a phase-locked loop. The phase-locked loop unit 410 includes a phase comparator 510, a charge pump 520, a filter 530, a voltage-controlled oscillator 540 and a frequency divider 550.

The phase comparator 510 receives an oscillating signal and a reference signal, and outputs a phase difference between the frequency of the oscillating signal and the frequency of the reference signal. The charge pump 520 charges or discharges the capacitor depending on the phase difference output from the phase comparator 510, to output a current corresponding thereto. The filter 530 uses a current output from the charge pump 520 to create a control signal, providing it to the voltage-controlled oscillator 540. The voltage-controlled oscillator 540 receives the control signal corresponding to the phase difference and oscillates the oscillating signal by reflecting the control signal in the correction gain level. Here, the control signal may be a voltage signal. The frequency divider 550 may divide the frequency of the oscillating signal output from the voltage-controlled oscillator 540 at a predetermined proportion.

The automatic frequency control unit 420 may also be implemented as a loop type unit. As shown, the automatic frequency control unit 420 may include the voltage-controlled oscillator 540, the frequency divider 550 and the automatic frequency controller 560.

The automatic frequency controller 560 receives a reference signal and a frequency-divided signal and detects the difference between the two signals. Then, the automatic frequency control unit 420 may determine whether to change the frequency gain level depending on the difference between the two signals, to create a gain level determining signal. The generated gain level determining signal is input to a corrector 570.

The correction unit 430 may be implemented as a corrector 570. The corrector 570 uses a gain level determining signal to determine a gain correction value.

The corrector 570 may determine the difference between the first gain level initially determined in the automatic frequency controller 560 and the input gain level as the gain correction value, to store it. The corrector 570 may determine the correction gain level by reflecting the stored gain correction value if a new input gain level is input. The determined correction gain level is provided to the voltage-controlled oscillator 540 as a correction gain level signal.

In an embodiment, the gain level may be determined using capacitor banks. In the embodiment, the voltage-controlled oscillator 540 may store a look-up table for a plurality of capacitor banks corresponding to a plurality of frequency gain levels, and may adjust the frequency dividing using a capacitor bank corresponding to the correction gain level.

In addition, the automatic frequency controller 560 may output a capacitor bank value (the first gain level) corresponding to the phase difference between the frequency of the oscillating signal and the frequency of the reference signal.

The corrector 570 may determine the gain correction value (capacitor bank correction value) from the difference between the look-up table for the capacitor bank and the first gain level (capacitor bank value) by the first operation of the automatic frequency controller 560.

Then, the corrector 570 may output the correction gain level (the corrected capacitor bank value) by reflecting the calculated capacitor bank correction value in each of the capacitor bank values output from the automatic frequency controller 560. That is, the corrector 570 may determine the correction gain level by reflecting the stored gain correction value in the look-up table from when the automatic frequency controller 560 operates for the second time.

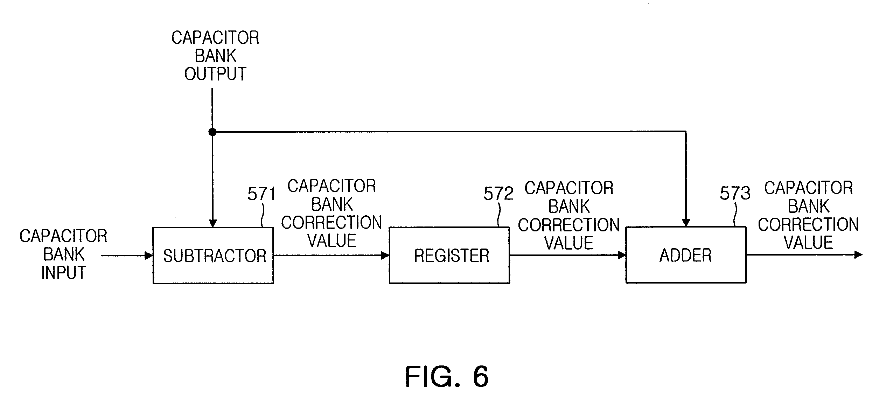

FIG. 6 is a block diagram illustrating an example of the corrector shown in FIG. 5. In the following, the example of the corrector 570 will be described in more detail with reference to FIG. 6.

Referring to FIG. 6, the corrector 570 includes a subtractor 571, a register 572, and an adder 573.

The subtractor 571 receives a capacitor bank output and a capacitor bank input, to subtract one from the other. Here, the capacitor bank output is a capacitor bank value output from an IC, and the capacitor bank input is a value output from the automatic frequency controller 560. Therefore, the value calculated in the subtractor 571 corresponds to the above-described gain correction value.

In an embodiment, the subtractor 571 may use the value when the automatic frequency controller 560 operates for the first time to perform subtraction. The subtractor 571 may operate at the time of first locking only. This is because the correction value of the capacitor bank is independent of the number of locking, such that the same correction value detected at the first operation may be used in the later operations.

The register 572 stores the capacitor bank difference value output from the subtractor 571, that is, the gain correction value. The register 572 may provide the output capacitor bank difference value stored therein to the adder 573 whenever the loop of the automatic frequency controller 560 operates one time.

The adder 573 may add the difference value stored in the register 572 to the capacitor bank output, outputting a capacitor bank correction value (correction gain level).

Accordingly, the capacitor bank correction value output from the subtractor 573 may correct a frequency error due to an error in a process or a circuit. That is, in the example described with reference to FIG. 3, after the capacitor banks are sequentially searched for five times in the first loop, the subtractor 571 may determine the value 5 as the correction value. The register 572 stores the value of 5, and the subtractor 573 may reflect the correction value of 5 in the every output capacitor bank value of the automatic frequency controller 560. By doing so, in the embodiment of the present invention, locking time is required only in the first operation and lock may be immediately performed from the second time.

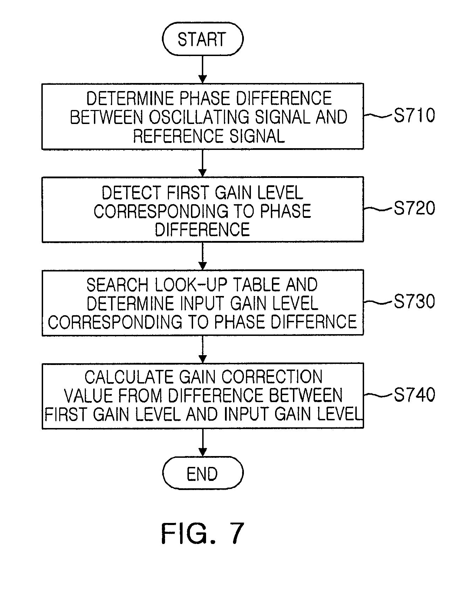

FIG. 7 is a flowchart for illustrating a method of controlling a frequency synthesizer according to an embodiment of the present invention.

The method illustrated in FIG. 7 will be described with respect to the frequency synthesizer described with reference to FIGS. 4 to 6, and, therefore, descriptions on the same elements as those described above will not be repeated.

The method of controlling the frequency synthesizer includes determining a phase difference between the frequency of a frequency-divided oscillating signal and the frequency of a reference signal (S710).

Then, a first gain level corresponding to the phase difference is detected by automatic frequency control (S720), and look-up tables of capacitor banks are sequentially searched, so that the input gain level corresponding to the phase difference may be determined (S730).

In the embodiment in operation S730, the frequency synthesizer may use locking information when the automatic frequency control is initially performed, to determine a first gain level.

Then, a gain correction value may be calculated based on the difference between the first gain level and the input gain level (S740).

Additionally, the frequency synthesizer may reflect the gain correction value in the first gain level by the phase difference due to driving after the automatic frequency control is driven for the second time. Further, the frequency synthesizer may dividing the frequency of the oscillating signal again by reflecting the gain correction value, determining the phase difference based on the oscillating signal which was frequency-divided again (S710).

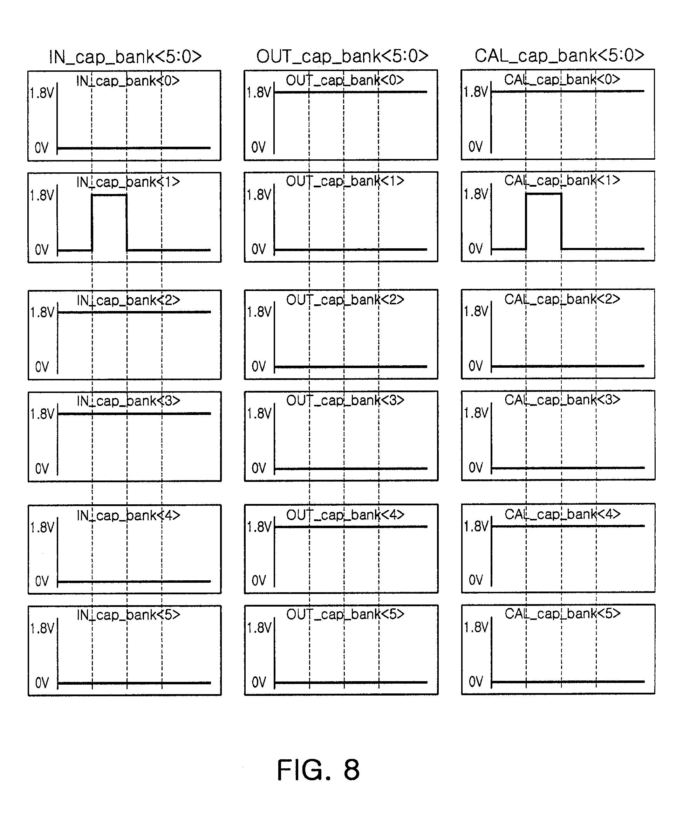

FIG. 8 is a graph showing simulation data according to an embodiment of the present invention.

IN_cap_bank corresponds to an input of the capacitor banks, and OUT_cap_bank in the middle column corresponds to an output of the capacitor banks.

It can be seen from the data in the left column that IN_cap_bank<5:0> initially selects 12th (bin:"00 1100") capacitor bank, and it can be seen from the data in the middle column that OUT_cap_bank<5:0> outputs 17 (bin:"01 0001"). In the data in the right column, CAL_cap_bank<5:0> outputs 17 (bin:"01 0001").

When IN_cap_bank<5:0> is changed from 12 to 14 for the first time, namely, when the frequency is changed to 1140 MHz, IN_cap-bank uses 14 (bin:"00 1110") according to the look-up table. Here, it can be seen that CAL_cap_bank<5:0> exhibits 19 (bin: "01 0011").

In the related art, when the frequency is changed to 1140 MHz, 14 is input to IN_cap_bank<5:0> so as to repeat a predetermined locking process, and thus the AFC block sequentially searches the capacitor banks in the order of from 12 to 17, thereby increasing the overall locking time.

According to the embodiment of the present invention, however, although 1140 MHz is the 12th capacitor bank in the look-up table as shown in the result of the simulation, the deviation value is internally searched so that actually the 17th capacitor bank is directly selected. Accordingly, the locking time is not increased even if there is a deviation in an IC, thereby optimizing the locking time in any case.

As set forth above, according to the embodiments of the present invention, a deviation is determined in the first locking process, and the determined deviation is reflected in selecting a capacitor bank to thereby eliminating the sequential locking process. Accordingly, correction can be performed with one time locking, thereby decreasing locking time.

While the present invention has been shown and described in connection with the embodiments, it will be apparent to those skilled in the art that modifications and variations can be made without departing from the spirit and scope of the invention as defined by the appended claims.

## Claims

1. A frequency synthesizer, comprising:
a phase-locked loop unit detecting a phase difference between a frequency of a frequency-divided oscillating signal and a frequency of a reference signal so as to adjust dividing of the frequency of the oscillating signal so that the phase difference is decreased within a range of the correction gain levels;
an automatic frequency control unit sequentially searching a plurality of frequency gain levels so as to determine a first gain level corresponding to the phase difference between the frequency of the frequency-divided oscillating signal and the frequency of the reference signal; and
a correction unit determining a gain correction value using the first gain level so as to determine the correction gain level by reflecting the gain correction value.

2. The synthesizer of claim 1, wherein the phase-locked loop unit includes:
a phase comparator receiving the oscillating signal and the reference signal so as to output a phase difference between the frequency of the oscillating signal and the frequency of the reference signal; and
a voltage-controlled oscillator receiving a control signal corresponding to the phase difference and adjusting the frequency dividing by reflecting the control signal in the correction gain level so as to oscillate the oscillating signal.

3. The synthesizer of claim 2, wherein the voltage-controlled oscillator stores look-up tables for a plurality of capacitor banks corresponding to the plurality of frequency gain levels, and adjusts the frequency dividing using a capacitor bank corresponding to the correction gain level.

4. The synthesizer of claim 1, wherein the correction unit determines a difference between the first gain level initially determined in the automatic frequency control unit and the input gain level as the gain correction value, and stores it.

5. The synthesizer of claim 4, wherein the correction unit determines the correction gain level by reflecting the stored gain correction value when a new input gain level is input.

6. The synthesizer of claim 2, wherein the phase-locked loop includes:
a charge pump charging or discharging capacitors according to the phase difference output from the phase comparator; and
a filter generating the control signal using a current output from the charge pump.

7. A frequency synthesizer, comprising:
a phase-locked loop detecting a phase difference between a frequency of a frequency-divided oscillating signal and a frequency of a reference signal so as to adjust dividing of the frequency of the oscillating signal so that the phase difference is decreased within a range of the correction gain levels;
an automatic frequency control unit searching a plurality of frequency gain levels so as to determine a first gain level corresponding to the phase difference between the frequency of the frequency-divided oscillating signal and the frequency of the reference signal; and
a correction unit determining a gain correction value based on the first gain level by a first operation of the automatic frequency control unit, and reflecting the gain correction value from when the automatic frequency control unit operates for the second time.

8. The synthesizer of claim 7, wherein the phase-locked loop unit includes:
a phase comparator receiving the oscillating signal and the reference signal so as to output a phase difference between the frequency of the oscillating signal and the frequency of the reference signal; and
a voltage-controlled oscillator receiving a control signal corresponding to the phase difference and adjusting the frequency dividing by reflecting the control signal in the correction gain level so as to oscillate the oscillating signal.

9. The synthesizer of claim 8, wherein the voltage-controlled oscillator stores look-up tables for a plurality of capacitor banks corresponding to the plurality of frequency gain levels, and adjusts the frequency dividing using a capacitor bank corresponding to the correction gain level.

10. The synthesizer of claim 8, wherein the correction unit determines the gain correction value from a difference between a look-up table for the capacitor bank and the first gain level by the first operation.

11. The synthesizer of claim 10, wherein the correction unit determines the correction gain level by reflecting the gain correction value in the look-up table from when the automatic frequency control unit operates for the second time.

12. The synthesizer of claim 8, wherein the phase-locked loop includes:
a charge pump charging or discharging capacitors according to the phase difference output from the phase comparator; and
a filter generating the control signal using a current output from the charge pump.

13. A method of controlling a frequency synthesizer using capacitor banks, the method comprising:
determining a phase difference between a frequency of a frequency-divided oscillating signal and a frequency of a reference signal;
detecting a first gain level corresponding to the phase difference through automatic frequency control;
sequentially searching look-up tables for capacitor banks to determine an input gain level corresponding to the phase difference; and
calculating a gain correction value from the difference between the first gain level and the input gain level.

14. The method of claim 13, wherein the detecting of the first gain level includes determining the first gain level using locking information when the automatic frequency control is operated for the first time.

15. The method of claim 14, further comprising reflecting the gain correction value in the first gain level by the phase difference by the operation from when the automatic frequency control is operated for the second time.

16. The method of claim 15, further comprising dividing the frequency of the oscillating signal again by reflecting the gain correction value, so as to perform the determining of the phase difference again based on the oscillating signal which was frequency-divided again.
